(19) Europäisches Patentamt / European Patent Office / Office européen des brevets

(11) **EP 3 205 631 B1**

(12) **EUROPÄISCHE PATENTSCHRIFT**

(45) Veröffentlichungstag und Bekanntmachung des Hinweises auf die Patenterteilung:
**11.03.2020 Patentblatt 2020/11**

(21) Anmeldenummer: **16155752.5**

(22) Anmeldetag: **15.02.2016**

(51) Int Cl.:
*C03C 17/00* (2006.01)      *A01N 59/20* (2006.01)
*C03C 17/22* (2006.01)      *C03C 17/23* (2006.01)
*C03C 17/34* (2006.01)      *C03C 17/42* (2006.01)
*C23C 14/00* (2006.01)      *C23C 14/35* (2006.01)

(54) **ANTIMIKROBIELLE GLASBESCHICHTUNG**

ANTIMICROBIAL GLASS COATING

REVETEMENT DE VERRE ANTIMICROBIEN

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**16.08.2017 Patentblatt 2017/33**

(73) Patentinhaber: **Glas Trösch Holding AG**
**6374 Buochs (CH)**

(72) Erfinder:
• **MEIER, Pascal**
**4800 Zofingen (CH)**
• **HAAG, Walter**
**9472 Grabs (CH)**
• **ROMANYUK, Andriy**
**4500 Solothurn (CH)**

(74) Vertreter: **Troesch Scheidegger Werner AG**
**Schwäntenmos 14**
**8126 Zumikon (CH)**

(56) Entgegenhaltungen:
EP-A1- 2 392 690          DE-A1-102005 013 857
DE-A1-102006 060 057      DE-A1-102010 054 046
US-A1- 2009 162 695       US-A1- 2015 208 664

• TE-WEI CHIU ET AL: "Antibacterial property of CuCrO2 thin films prepared by RF magnetron sputtering deposition", VACUUM., Bd. 87, 1. Januar 2013 (2013-01-01), Seiten 174-177, XP055276111, GB ISSN: 0042-207X, DOI: 10.1016/j.vacuum.2012.04.026
• KAMIMURA K ET AL: "PREPARATION OF CUPROUS OXIDE (CU2O) THIN FILMS BY REACTIVE DC MAGNETRON SPUTTERING", IEICE TRANSACTIONS ON ELECTRONICS, INSTITUTE OF ELECTRONICS, TOKYO, JP, Bd. E87-C, Nr. 2, 1. Februar 2004 (2004-02-01), Seiten 193-196, XP001047524, ISSN: 0916-8524
• NOSAKA T ET AL: "Copper nitride thin films prepared by reactive radio-frequency magnetron sputtering", THIN SOLID FILMS, ELSEVIER-SEQUOIA S.A. LAUSANNE, CH, Bd. 348, Nr. 1-2, 6. Juli 1999 (1999-07-06), Seiten 8-13, XP004177553, ISSN: 0040-6090, DOI: 10.1016/S0040-6090(98)01776-3

## Beschreibung

Die Erfindung betrifft einen mit einer antimikrobiellen, insbesondere mit einer antibakteriellen Schicht versehenen Gegenstand nach dem Oberbegriff des Anspruches 1 sowie ein Verfahren zur Beschichtung eines Gegenstandes mit einer antimikrobiellen, insbesondere antibakteriellen Schicht nach Ansprüche 11 und 13.

Aus dem Stand der Technik sind verschiedene Verfahren bekannt, um unterschiedlichen Oberflächen antimikrobielle Eigenschaften zu verleihen, wie bspw. DE 10 2006 060057 A1.

Beispielsweise offenbart US2015/0225288A1 ein Verfahren um durch eine Abfolge von chemischen Bädern Silberionen mit über Ionenaustausch ersetzbaren Metallionen in die Oberfläche eines Glassubstrats einzubringen.

Demgegenüber offenbart EP1828071B2 ein Verfahren zur Herstellung eines Glassubstrats, das mit einer gemischten Schicht aus einem antimikrobiellen Wirkstoff und einem Bindermaterial durch einen Sputterprozess beschichtet ist. Grundsätzlich können ganz unterschiedlichen Substraten entsprechende Eigenschaften verliehen werden.

Eine Aufgabe der vorliegenden Erfindung ist es, einen Gegenstand zur Verfügung zu stellen, der auch bei trockener Oberfläche eine besonders wirksame antimikrobielle Beschichtung zumindest einer Oberfläche bei guter Haftung aufweist. Eine weitere Aufgabe der Erfindung ist es, einen transparenten Gegenstand zur Verfügung zu stellen, der eine entsprechende antimikrobielle Beschichtung mit besonders guten optischen Eigenschaften aufweist. Die antimikrobielle Wirkung, insbesondere die antibakterielle Wirkung soll sich dabei kurzfristig entwickeln, so dass bereits innerhalb einer Stunde ein Grossteil der Mikroorganismen abgetötet wird.

Des Weiteren ist es Aufgabe der Erfindung ein Verfahren aufzuzeigen, mittels dessen eine oder mehrere Oberflächen von Gegenständen unterschiedlicher Geometrie wirtschaftlich mit einer entsprechenden antimikrobiellen Beschichtung versehen werden können. Dabei soll das Verfahren insbesondere für das Beschichten grossflächiger, beispielsweise im Wesentlichen planarer Substrate und/oder für die optisch hochwertige Beschichtung von Oberflächen geeignet sein.

Lediglich als beispielhafte Auswahl sind im Folgenden verschiedene Gegenstände, deren Oberfläche oder Oberflächen mit dem entsprechenden Verfahren beschichtete werden können und entsprechende Einsatzbereiche genannt:

Displaygläser, Display-Vorsatzgläser; Einsätze, Panels oder komplette Oberflächen von Ticket- und Geldautomaten; Aufzugspanels, Lichtschalter, Steuerungselemente, Auto-Cockpits, medizinische Verpackungssysteme; Einsätze, Panels, Abdeckungen, Vorsätze, Fronten oder ganze Oberflächen von Wänden, Türen, Ablagen, Möbel (Regale, Tische) Küchen, Badezimmer, Duschen, Spiegeln; dabei insbesondere entsprechende Gegenstände wie sie in öffentlichen Einrichtungen und/oder Krankenhäusern eingesetzt werden.

Zumindest eine der oben gestellten Aufgaben oder eine Kombination davon wird durch die unabhängigen Ansprüche 1 oder 11 und 13 in vorteilhafter Weise gelöst.

Dabei weist ein Gegenstand mit einer auf zumindest einer Oberfläche des Gegenstands angeordneten Beschichtung, zumindest eine antimikrobiell wirkende Schicht auf, die eine Kupfer(I)-Verbindung oder/und eine Kupfer(II)-Verbindung als antimikrobielles Mittel umfasst. Das antimikrobielle Mittel kann dabei ein Oxid, ein Oxinitrid oder ein Nitrid sein. Bevorzugt ist das Mittel eine Kupfer(I) Verbindung, da sich solche Verbindungen, dabei insbesondere $Cu_2O$ und $Cu_3N$, als besonders wirksam gezeigt haben.

Die kupferhaltige Verbindung ist dabei in der Schicht in einer solchen Konzentration vorhanden, dass sie zumindest 2 at% Kupfer, bevorzugt zumindest 6 at% Kupfer umfasst.

Die Schicht kann dabei neben Kupfer, Silizium, Stickstoff, Sauerstoff und fakultativ ein oder mehrere Dotierelemente D enthalten, bzw. aus diesen Elementen aufgebaut sein. Dabei sind in der Schicht vorteilhaft zumindest 25 at% Silizium, zumindest 40 at% Nichtmetalle, bspw. zumindest 15 at% Stickstoff und zumindest 25 at% Sauerstoff, sowie das oder die Dotierelemente D gesamthaft in einem Bereich von $0 \leq D \leq 15$ at% enthalten. Die jeweiligen Obergrenzen ergeben sich dabei entsprechend der von 100 at% abgezogenen Summe der Untergrenzen der anderen Elemente, bspw. 35 at% für Kupfer bzw. 58 at% für Silizium. Bevorzugt wird jedoch nicht mehr als 15 at% Cu, nicht mehr als 45 at% Si, nicht mehr als 31 at% N, nicht mehr als 45 at% 0 und nicht mehr als 10 at% D in der Schicht eingebaut. Dies insbesondere dann, wenn dabei zusätzlich noch ein Verhältnis, alle Angaben in at %,

$$G = (Cu + Si)/(Cu + Si + N + O + D)$$

aller in der antimikrobiellen Schicht enthaltenen Elemente von $32 \leq G \leq 52$ ingestellt wurde.

Als sowohl bezüglich der antimikrobiellen als auch der optischen Eigenschaften, die besonders für die Beschichtung von Gläsern von Bedeutung sind, günstiger Bereich der jeweiligen elementbezogenen Schichtzusammensetzung hat sich, wie in den Beispielen unten im Detail besprochen, die Einstellung zumindest eines der folgenden Bereiche gezeigt (alle Angaben in at%): 6 ≤ Cu ≤ 8, 33 ≤ Si ≤ 37, 21 ≤ N ≤ 25, 32 ≤ O ≤ 38, D ≤ 3 und 37 ≤ G ≤ 47. Es hat sich dabei gezeigt, dass bereits die Einstellung eines besonders günstigen Bereichs in Kombination mit den weiter oben genannten grösseren erfindungsrelevanten Bereichen vorteilhaft ist, diese je nach Anwendungszweck aber auch einzeln oder frei miteinander kombiniert werden können. So kann, beispielsweise um der Schicht besonders gute Hafteigenschaften zu verleihen, der Silizium und Sauerstoffgehalt zumindest einer Schichtoberfläche im Rahmen des erfindungsgemäss offenbarten Cu /(Cu+Si) Verhältnisses I, bzw. im Rahmen des erfindungsgemäss offenbarten O/(O+N) Verhältnisses H erhöht werden um die durch $SiO_2$-Moleküle oder Cluster belegte Rand- bzw.

Oberflächenbereiche der Schicht zu erhöhen. Alternativ können Schichtoberflächenbereiche, die direkt auf dem Substrat bzw. auf der Oberfläche des Substrats oder der Zwischenschicht abgelegt sind, auch als reine $SiO_2$-Schichten ausgebildet sein. Bei Bedarf kann der Schichtübergang zur oder von der antibakteriellen Schicht jeweils gradiert ausgebildet sein.

Die Dicke d der antimikrobiellen Schicht wurde dabei in einem Bereich von 1 ≤ d ≤ 130 nm, bevorzugt von 5 ≤ d ≤ 80 nm, insbesondere bevorzugt von 10 ≤ d ≤ 50 nm eingestellt.
Der Gegenstand kann dabei zumindest an der Oberfläche aus Metall, Kunststoff, Keramik oder Glas bestehen.

Als Dotierelement D können folgende Elemente, insbesondere Metalle, entweder einzeln oder in Kombination verwendet werden: Ag, Al, As, Cd, Cr, Fe, Mn, Ni, Sn, Zn. Dadurch können u.a. folgende Eigenschaften gezielt beeinflusst werden.

Farbe: Durch Zugabe von Cr, Mn, Ni, Sn oder Zn;

Korrosionsbeständigkeit: Durch Zugabe von Al, As, Cr, Fe, Mn, Ni, Sn;

Verschleissbeständigkeit: Durch Zugabe von Ag, Al, Cd, Sn.

Die Korrosions- und Verschleissbeständigkeit kann dabei ebenso, wie die Haftung der Schicht bzw. deren Eignung für eine zusätzliche Beschichtung auch durch den Si-Gehalt eingestellt werden.

Des Weiteren kann zwischen der Schicht und der Oberfläche, beispielsweise zur Verbesserung der Haftung, zur gradierten Anpassung des Brechungsindexes, zum Erzeugen einer Antireflex(AR)-Schicht oder Ähnlichem, zumindest eine Zwischenschicht angeordnet sein. Alternativ oder zusätzlich kann in einer weiteren Ausführungsform der Erfindung auf der Schichtoberfläche eine hydro- und / oder oleophobe Schicht, eine sogenannte "Easy-to-Clean-Schicht", angeordnet sein, um die Reinigung des Gegenstands zu erleichtern. Diese kann bspw. aus Fluorosilanen aufgebaut sein. Solche Schichten bringen wesentliche Vorteile, da damit schon von Anfang an weniger mikrobielle Erreger auf die Oberfläche gelangen, so verringert bspw. eine Fluorosilanschicht die Anzahl der durch Berühren der Oberfläche von Hand übertragenen Bakterien um 60%. Dabei wurde erkannt, dass diese besonders gut an den $SiO_2$-reichen Oberflä-chenbereichen der Schicht haftet, die durch die erfindungsgemässe Einstellung des Cu/(Cu+Si)-Verhältnisses I stets an der Oberfläche vorhanden sind. Dazu kann der Beschichtungsprozess auch so geführt werden, dass bei der Abscheidung der antibakteriellen Schicht an deren Oberfläche, bei Bedarf, bspw. über eine Gradientenschicht mit dieser verbunden, eine $SiO_2$-reichere Schicht ausgebildet wird, bspw. durch Einstellung des Verhältnisses 5 ≤ I ≤ 15, die als Haftschicht für die Fluorosilanschicht dient, ohne dabei die antimikrobiellen Eigenschaften zu verlieren bzw. zu sehr abzuschwächen. Zusätzlich oder alternativ kann eine solche Haftschicht auch als Zwischenschicht vorgesehen sein, wobei in diesem Fall auch eine reine $SiO_2$-Schicht als Haftschicht verwendet werden kann.

In einer weiteren Ausführungsform der Erfindung ist der Gegenstand ein Glas, wobei Glas hier in seiner allgemeinsten Bedeutung gemeint ist und daher neben den üblichen anorganischen bzw. mineralischen Gläsern auch organische Gläser aus polymeren Werkstoffen wie beispielsweise Polymethylacrylat (PMMA), Polycarbonat (PC), CR39 oder anderen geeigneten Polymeren und Polymermischungen umfasst.

Insbesondere für Gegenstände aus Glas kann die Zwischenschicht eine Antireflexschicht umfassen, die zumindest eine hochbrechenden und / oder eine tiefbrechenden Schichtlage umfasst. Für höhere optische Anforderungen kann jedoch bevorzugt eine Antireflexschicht aus zumindest zwei hochbrechenden und zwei tiefbrechenden Schichtlagen verwendet werden. Zusätzlich oder alternativ kann auch auf einer der antibakteriellen Schicht gegenüberliegenden Oberfläche des Gegenstands eine aus zumindest einer hochbrechenden und einer tiefbrechenden Schichtlage, dabei bevorzugt aus zumindest zwei hochbrechenden und zwei tiefbrechenden Schichtlagen bestehende Antireflexschicht angeordnet sein.

Die hochbrechende Schicht kann bspw. $TiO_2$, $Nb_2O_5$, $Si_3N_4$ und die tiefbrechende Schicht beispielsweise $SiO_2$, ZnO, $SnO_2$, $ZnSnO_3$, $ZrO_2$ umfassen bzw. aus zumindest einem dieser Materialien bestehen.

Zur Optimierung der Schichteigenschaften, insbesondere auf Glas, sollte die Schicht nicht mehr als 8 at% Cu, nicht mehr als 37 at% Si und nicht mehr als 25 at% N und nicht mehr als 38 at% O enthalten, womit optimale optische Eigenschaften für die Schicht sichergestellt werden können.

Eine weitere Aufgabe der Erfindung ist es ein Verfahren zur Beschichtung eines Gegenstandes mit zumindest einer antimikrobiellen, insbesondere einer antibakteriellen Schicht zur Verfügung zu stellen. Ein solches Verfahren umfasst zumindest folgende Schritte:

- Bereitstellen einer Sputteranlage mit zumindest einem kupferhaltigen Target;

- Einbringen des Gegenstandes in die Sputteranlage;

- Erzeugen eines Vakuums in der Sputteranlage;

- Einlassen eines inerten Sputtergases sowie eines Sauerstoff und/oder Stickstoff enthaltenden Reaktivgases;

- Zünden und Aufrechterhalten einer Sputterentladung am Target

- Einstellen des Reaktivgasflusses so, dass auf dem Gegenstand eine Kupfer(I)-Verbindung oder/und eine Kupfer(II)-Verbindung, dabei bevorzugt ein Oxid, ein Oxinitrid oder/und ein Nitrid des Kupfers enthaltende Schicht abgeschieden wird.

Bevorzugte Reaktivgase sind dabei Sauerstoff und/oder Stickstoff.

Des Weiteren bevorzugt wird dabei eine Kupfer(I) Verbindung, insbesondere $Cu_2O$ und $Cu_3N$, abgeschieden.

In einer Verfahrensvariante wird dabei zumindest ein CuSi-Target und/oder ein CuSiN-Target verwendet, wobei ein Verhältnis, alle Angaben in at%,

$$I_T = Cu / (Cu + Si)$$

im Target in einem Bereich von $5 \leq I_T \leq 40$, dabei bevorzugt in einem Bereich von $15 \leq I_T \leq 30$ vorliegt. Dabei können im Target die Elemente Cu und Si in metallischer, in teilweise oder gänzlich oxidierter Form bspw. als Nitrid, Oxid oder Oxynitrid vorliegen, bspw. als $Cu_2O$, $Cu_3N$, $CuO$, $SiO_2$, $Si_3O_4$, $Cu_aSi_bN_cO_d$, $Cu_eSi_fN_g$, $Cu_hSi_iO_j$, oder als deren Mischoxide, Mischnitride oder Mischoxinitride. Die Koeffizienten a bis j können dabei entsprechend einer oder mehrerer Verbindungen oder auch entsprechend unter- bzw. überstöchiometrisch eingestellt werden. Soll bspw. eine Schicht mit sehr hohem oder ausschliesslichem Kupfer(I)-Anteil abgeschieden werden, kann bspw. ein aus einer oder mehreren Kupfer(I)-Verbindungen aufgebautes Target verwendet werden. Alternativ können auch Targets mit einem Anteil aus metallischem Kupfer und einem Anteil aus einer oder mehreren Kupfer(I) und/oder Kupfer(II)-Verbindungen verwendet werden, wodurch je nach Einstellung der Prozessparameter entweder Schichten, die metallisches Kupfer als auch Kupfer(I)- bzw. Kupfer(II)-Verbindungen oder, bspw. bei höherem Sauerstoff- und/oder Stickstoffanteil im Prozessgas, auch $Cu_aSi_bN_cO_d$-Schichten mit ausschliesslich oxidierten Kupferverbindungen enthalten, abgeschieden werden können.

Zusätzlich kann dabei die Einstellung des Partialdrucks des sauerstoffhaltigen Gases sowie des Partialdrucks des stickstoffhaltigen Gases so eingestellt werden, dass in der Schicht ein Verhältnis, alle Angaben in at%,

$$H = N / (N + O) \quad von \quad 30 \leq H \leq 50 \text{ ,}$$

vorliegt. Dies kann, bspw. nach anfänglicher Einstellung der Gasflüsse auf gewünschte Ausgangswerte, durch eine Regelung der Gasflüsse mittels einer prozessbegleitenden Messung der jeweiligen Schichtzusammensetzung erfolgen, wobei der jeweils gemessene Stickstoff- bzw. Sauerstoffgehalt in der Schicht zur Regelung des entsprechenden Gasflusses verwendet wird. Entsprechende Verfahren sind dem Fachmann der Beschichtungstechnik bekannt.

Durch diese Einstellung des Stickstoff/Sauerstoff-Verhältnisses lässt sich überraschenderweise das Gleichgewicht zugunsten der Bildung von $Cu_2O$ anstelle von $CuO$ verschieben. Es wird also die Bildung der bezüglich ihrer antimikrobiellen, bzw. antibakteriellen Wirkung aktiveren Kupfer(I)-Verbindung gegenüber der schwächer aktiven Kupfer(II)-Verbindung bevorzugt, wodurch trotz einer verhältnismässig geringen Cu-Konzentration eine hohe antimikrobielle, bzw. antibakterielle Wirkung erzielt werden kann. Gleichzeitig sollte der Sauerstoffgehalt nicht kleiner eingestellt werden, da sonst Brechwert und Absorption der Schicht steigen, was zumindest für die Beschichtung üblicher Gläser nachteilig ist.

Die Mischtargets können dabei auf unterschiedliche Art und Weise, bspw. durch schmelz- oder durch pulvermetallurgische Verfahren hergestellt werden, wobei sich Letztere für die Herstellung ganz unterschiedlicher Target-Zusammensetzungen eignen, da sich die Ausgangsmaterialien (Si, $SiO_2$, $Si_3N_4$, Cu, $Cu_2O$, $Cu_3N$, etc. siehe auch oben) beliebig mischen und pressen lassen. Als Beispiele für pulvermetallurgische Verfahren, die zum Herstellen von Targets verwendet werden können seien hier das HIP-Verfahren (Heiss-Isostatisch-Pressen), das sich besonders für planare Targetgeometrien eignet, als auch verschiedene thermische Spritzverfahren, wie Flammspritzen, Lichtbogenspritzen, Plasmaspritzen und Vakuumplasmaspritzen, die sich auch sehr gut für die Herstellung von bspw. zylindrischen Rohrkathoden eignen, angeführt.

Alternativ können auch Mosaik- oder Pfropftargets verwendet werden, bei denen zumindest in dem abzusputternden Bereich der Oberfläche beispielsweise eines Si- oder $Si_3N_4$-Targets Cu- oder $Cu_3N$-Pfropfen oder Inlays eingebracht werden.

Ein solches Verfahren ist für die industrielle Produktion vorteilhaft, da der Regelungsaufwand, auf Grund des im Wesentlichen konstanten Cu/Si-Verhältnis des gesputterten CuSi-Materials, gering ist und flächige oder auch dreidimensional ausgebildete Substrate bspw. mittels Inline-Anlagen durchlaufend beschichtet werden können.

Alternativ kann ein solches Verfahren zur Beschichtung eines Gegenstandes mit zumindest einer antimikrobiellen bzw. antibakteriellen Schicht auf einer Sputteranlage mit zumindest einem Cu-Target, einem Kupfer(I), wie bspw. $Cu_3N$ oder/und $Cu_2O$, enthaltenden Target, einem Kupfer(II), wie bzw. antibakteriellen Schicht auf einer Sputteranlage mit zumindest einem Cu-Target, einem Kupfer(I), wie bspw. $Cu_3N$ oder/und $Cu_2O$, enthaltenden Target, einem Kupfer(II), wie bspw. CuO oder/und $Cu_3N_2$, oder beide Oxidationsstufen des Kupfers enthaltenden Target und zumindest einem Si-Target, einem Siliziumoxid, wie bspw. $SiO_2$, enthaltenden Target oder/und einem Siliziumnitrid, wie beispielsweise $Si_3N_4$, enthaltenden Target ausgeführt werden wobei die kupferhaltigen und siliziumhaltigen Targets bspw. beide überlappend auf die zu beschichtende Oberfläche ausgerichtet sind.

Die einzelnen Schritte des Verfahrens sind dabei dieselben wie oben dargestellt, wobei allerdings zusätzlich noch eine Einstellung bzw. Regelung der Sputterraten bspw. am Cu-Target und am Si-Target erfolgen muss, um in der Schicht ein Verhältnis, alle Angaben in at%,

$$I = Cu \, / \, (Cu + Si) \quad von \quad 5 \leq I \leq 30$$

einzustellen. Die Regelung der Sputterraten kann dabei analog zur Regelung der Gasflüsse mittels einer prozessbegleitenden Messung der jeweiligen Schichtzusammensetzung erfolgen, wobei der jeweils gemessene Kupfer- bzw. Siliziumgehalt in der Schicht zur Regelung des entsprechenden Gasflusses verwendet wird.

Eine weitere Verfahrensalternative, bei der der zu beschichtende Gegenstand, wie im ersten Verfahrensbeispiel, auch durch ein einzelnes Target beschichtet werden kann, Materialzusammensetzung der drehenden Oberfläche des Rohrtargets durch Ein-/Ausschalten und falls gewünscht durch Regelung der weiteren Sputterquelle gezielt verändert werden. Letztere ist dabei optisch, zumindest durch die Sputterquelle mit dem rotierenden Rohrtarget, von der Kammer in der der Gegenstand beschichtet wird getrennt und kann bspw. ihrerseits als Planarmagnetronquelle oder als weitere Rohrmagnetronquelle ausgeführt sein.

Die Sputterquelle mit dem rotierenden Target ist dabei zur Beschichtungskammer als Magnetron ausgebildet um den Gegenstand zu beschichten und kann ihrerseits auf der der Beschichtungskammer abgewandten Seite durch die weitere Sputterquelle beschichtet werden. Auch dadurch können, bswp. ähnlich wie bei dem Verfahren mit zwei überlappend auf den Gegenstand gerichteten Sputterquellen, je nach Materialwahl des Rohrtargets und des Targets der weiteren Sputterquelle, Schichtgradienten, stufenförmige Änderungen, bspw. des Kupfer/Siliziumgehalts, des Gehalts des oder der Dotierelemente oder auch nur ein konstanter, aber von Charge zu Charge unterschiedlich einstellbarer Gehalt eines oder mehrerer Dotierelemente auf der Oberfläche des zu beschichtenden Gegenstands hergestellt werden.

Solche Verfahren haben Vorteile, wenn abwechselnd Schichten mit unterschiedlichem Cu/Si Verhältnis hergestellt werden sollen, erfordern aber einen höheren Regelungsaufwand.

Zusätzlich kann beispielsweise eine metallische Haftschicht aus Kupfer oder eine $SiO_2$-Haftschicht auf der Oberfläche des Gegenstands erzeugt werden, indem bspw. bei einer Durchlaufanlage zunächst eine mit entsprechendem Target, bspw. aus Kupfer, Silizium oder Siliziumoxid, und geeigneter Sputter- bzw. Prozessgaseinstellung betriebene Beschichtungsstation durchlaufen wird.

Je nach eingesetztem Verfahren kann dabei entweder die Sputterleistung des zumindest einen CuSi-haltigen Targets, oder die Sputterleistung des Cu-haltigen Targets und die Sputterleistung des Si-haltigen Targets, so auf die Einstellung des Partialdrucks, bspw. des $O_2$ und des $N_2$ abgestimmt werden, dass sich in der Schicht ein Verhältnis, alle Angaben in at%,

$$G = (Cu + Si) \, /(Cu + Si + N + O) \quad von \quad 32 \leq G \leq 52$$

bzw.

$$G = (Cu + Si) / (Cu + Si + D + N + O) \quad von \quad 32 \leq G \leq 52$$

einstellt. Die Einstellung des Partialdrucks kann dabei zwar auch durch Differentialdruckmessung erfolgen, wird aber in der Regel durch die wesentlich einfachere Einstellung der entsprechenden Gasflüsse geregelt, wobei üblicherweise nur der Gesamtprozessdruck gemessen wird. Das Reaktivgas kann in jedem Fall auch erst nach Einlass des inerten Sputtergases und nach dem Zünden des oder der Targets eingelassen werden. Dies beispielsweise um die Targetoberfläche vor dem Beginn der Beschichtung hinter geschlossenen Blenden zu reinigen und/oder um eine metallische Haftschicht aufzubringen. Der Schichtübergang kann dabei wie auch bei den anderen oben erwähnten mehrlagigen Beschichtungen entweder stufenartig, wie bspw. bei den einzelnen Lagen einer AR-Schichten, oder gradiert, bspw. für den fliessenden Übergang einer Haftschicht erfolgen.

Vor der Besprechung der Erfindung an Hand von Beispielen wird zunächst die verwendete Messmethode zur Feststellung der antimikrobiellen, insbesondere der bakteriziden Wirksamkeit der Schicht erläutert, für die ein an die "Test Method for Efficacy of Copper Alloy Surfaces as a Sanitizer" der United States Environmental Protection Agency (EPA) angelehnter Test verwendet wurde. Das entsprechende EPA-Verfahren bezieht sich auf die am 16. Juli 2013 gültige Version, die von folgender Webseite geladen wurde: http://www.epa.gov. Dieses Verfahren eignet sich besonders zur Feststellung der antimikrobiellen Wirksamkeit von trockenen kupferhaltigen Oberflächen mit hohem und rasch wirkendem antimikrobiellem Effekt, wohingegen das bspw. in der EP1828071 angeführte Verfahren, gemäss Norm JIS Z 2801, antibakterielle Gläser in einer feuchten Umgebung in einem 24h-Zyklus testet und daher aus mehreren Gründen für den vorliegenden Zweck wenig geeignet ist.

Im Folgenden wird das verwendete Testverfahren beschrieben: Verwendetes Material:

- Bakterienkultur der entsprechenden Spezies

- sterilisiertes Wasser

- FCS (fötales Kälberserum)

- Testoberfläche

- Agarplatten

Ansatz zur Bestimmung der koloniebildenden Einheit (KBE, entspricht der englischen CFU oder colony forming unit) einer Kultur der zu untersuchenden bakteriellen Spezies nach Ausstreichen, Lufttrocknen und Replizieren mittels Plattenkultur: Serienmässiges Verdünnen der Bakterien um den Faktor $10^2$, $10^3$, $10^4$, $10^5$ in 20 μl Wasser mit 5% FCS und Ausstreichen auf ein 2 x 2 cm Referenzglas, gefolgt von 1h Lufttrocknen und Replizieren mittels Plattenkultur. Ein für die antimikrobielle Aktivitätsprüfung guter Wert liegt im Bereich zwischen 1 x $10^2$ - 3 x $10^2$ CFU (also Bakterien bzw. andere Mikroorganismen) pro Probe und erlaubt eine verlässliche Detektion einer 50% bis 95%-igen Wirksamkeit (killing rate). Anmerkung: Mit einem Photometer kann die Bakteriendichte bei $OD_{600}$ (d.h. Absorption bei 600 nm Wellenlänge), bestimmt werden, wobei eine Einheit etwa $10^9$ Bakterien entspricht.

Ablaufdetails

Die Bakterienkultur wird über Nacht gezüchtet und die Konzentration bestimmt. Die Bakterien werden in 5% FCS-haltigem, sterilem Wasser verdünnt. Das FCS dient als organische Verunreinigung zur Simulation einer Verschmutzung und hilft die Oberfläche zu befeuchten. Die Serienverdünnung in 5% FCS-haltigem Wasser wird angewandt um die erwünschte endgültige Verdünnung zu erreichen (siehe oben). 20 μl der erhaltenen Suspension werden homogen auf 2 x 2 cm Probeoberflächen verteilt und an Umgebungsluft getrocknet. Unbehandelte Glasplättchen dienen als Referenzmuster. Nach 60 Minuten werden die Bakterien durch gemässigtes, 10-sekündiges Anpressen der Probeplättchen auf Agar-Kontaktplatten transferiert.

Nach einer Bebrütung über Nacht bei 37°C werden die überlebenden Bakterienkolonien gezählt und der antimikrobielle Effekt der beschichteten Probe im Vergleich zu einer unbeschichteten Probe berechnet

Die Bestimmung der Mengenanteile der Schichtelemente (Cu, Si, N, O, D) und der daraus berechneten Verhältnisse (G, H, I), sowie die Bestimmung der in der Schicht vorliegenden Oxidationszahl(en) der Elemente, beispielsweise Kupfer (I) oder Kupfer (II), erfolgte durch Röntgenphotoelektronenspektroskopie (engl. X-ray photoelectron spectroscopy, XPS). Verwendet wurde eine monochromatische Al-K-alpha (1486.6 eV) Röntgenquelle zur Bestimmung des Flächenintegrals des Cu 2p 3/2, des Si 2p, des O 1s und des N 1s Signals.

Im Folgenden werden an Hand von Beispielen und tabellierten Bereichsangaben einzelne Aspekt der Erfindung im Detail erörtert.

Zur Herstellung von Probeplättchen wurden vorgereinigte Glasplatten in die Halterung einer PVD-Sputteranlage eingesetzt und in die Anlage eingeschleust. Die mit zwei auf eine planare Beschichtungsebene, bezüglich Ihres Zerstäubungskegels überlappend ausgerichteten Sputterquellen (Planarmagnetrone) bestückte Sputteranlage wurde dazu mit einem Cu-Target und einem Si-Target ausgerüstet. Nach Erzeugung eines Vakuums und Einstellen eines Sputterdrucks, in einem Bereich von $0.10 \leq p \leq 0.30$ Pa durch Einlassen von Inertgas (bspw. Ar) wurden die Sputterkathoden gezündet und damit von eventuellen oxidischen Rückständen gereinigt. Anschliessend wurde durch zusätzliches Einlassen von Stickstoff und Sauerstoff in einem jeweils gewünschten Verhältnis der Prozessdruck, in einem Bereich von $0.2 \leq p \leq 0.4$ Pa voreingestellt und die Leistung der Targets entsprechend dem gewünschten Cu/Si-Verhältnis und der gewünschten Schichtdicke geregelt. Darauf wurde eine Oberfläche des Glases dem Sputterplasma ausgesetzt und beschichtet. Anschliessend wurden die Glasplatten aus der Anlage geschleust, zu Probeplättchen vereinzelt und die antimikrobielle Wirksamkeit entsprechend oben beschriebenem Testablauf mit unterschiedlichen Spezies bestimmt.

Zusätzlich wurden die optischen Eigenschaften eines analog zu den Testplättchen, bzw. zu den Glasplatten beschichteten 4 mm dicken Normalglases (Kalk-Natron-Glas) nach der Beschichtung gemäss CIE Lab System mit Lichtart C unter einem Beobachtungswinkel von 2° bestimmt.

Im Folgenden ist ein Beispiel (Bsp.) der Voreinstellungen für einen Beschichtungsprozess gegeben, mit denen besonders gute antimikrobielle und optische Schichteigenschaften erreicht werden konnten:

Gasflüsse:

| | |
|---|---|
| Ar: | ca. 200 sccm |
| $N_2$: | ca. 100 sccm |
| $O_2$: | ca. 9 sccm |

Die exakten Gasflüsse wurden durch Bestimmung der während des Beschichtungsprozesses gemessenen Mengenanteile und Verwendung der entsprechenden Daten zur Feinregelung des Flusses automatisch nachgeführt.

Die Leistung auf dem Cu-Target wurde dabei auf 0.32 W/cm$^2$, die Leistung auf dem Si-Target mit 5.88 W/cm$^2$ eingestellt. Damit wurde eine 40 nm dicke Schicht mit folgender Zusammensetzung abgeschieden:

Cu: 7 at%, Si: 35 at%, N: 23 at%, O: 35 at% (G = 42, H = 40, I = 17)

Die dabei im Bereich des sichtbaren Lichts gemessenen optischen Eigenschaften wie Absorption, Transmission, Reflexion, sowie die Farbwerte bei Reflexion und Transmission finden sich in der Tabelle 3, die Ergebnisse der Auswertung der antimikrobiellen Eigenschaften der Beschichtung in den Tabellen 5 und 6.

Auf Grund der grossen durchgeführten Versuchszahl werden im Folgenden an Hand der Tabellen 1 bis 6, neben dem bereits oben besprochenen Ausführungsbeispiel mit der Zusammensetzung $Cu_{0.07}Si_{0.35}N_{0.23}O_{0.35}$ lediglich die Bereiche angeführt, in deren Grenzen sich die Erfindung ausführen lässt.

In Tabelle 1 werden die absoluten Werte der Mengenanteile der in der Schicht enthaltenen Elemente für die erfindungsgemäss vorteilhaften Bereiche 1 und 2, sowie die Werte des oben angeführten Beispiels angegeben.

Tabelle 1

| Element | Beispiel | Bereich 1 | Bereich 2 |
|---|---|---|---|
| Cu | 7 at% | 6 - 8 at% | 2 - 15 at% |
| Si | 35 at% | 33 - 37 at% | 25 - 45 at% |
| N | 23 at% | 21 - 25 at% | 15 - 31 at% |
| O | 35 at% | 32 - 38 at% | 25 - 45 at% |

Demgegenüber werden in Tabelle 2 die erfindungsgemäss für die Einstellung guter antimikrobieller, bzw. günstiger optischer Eigenschaften auszuwählenden Bereiche der Verhältniszahlen G, H, I dargestellt. Wenn auch die Bereiche 1' bzw. 2' innerhalb der Bereiche 1 bzw. 2 liegen, sind erstere wie unten näher erläutert, überraschenderweise besser zur gezielten Einstellung der gewünschten Schichteigenschaften geeignet, als wenn die Einstellung lediglich gemäss der Mengenanteile erfolgt.

Tabelle 2

| Verhältnis | Beispiel | Bereich 1' | Bereich 2' |
|---|---|---|---|
| I=Cu/(Cu+Si) | 17 at% | 15 - 20 at% | 5 - 30 at% |

(fortgesetzt)

| Verhältnis | Beispiel | Bereich 1' | Bereich 2' |
|---|---|---|---|
| H=N/(N+O) | 40 at% | 35 - 45 at% | 30 - 50 at% |
| G=(Cu+Si)/(Sum.) | 42 at% | 37 - 47 at% | 32 - 52 at% |

Hierzu ist anzumerken, dass bezüglich der in der erfindungsgemässen Schicht tatsächlich erfolgten Phasenbildung die Ausbildung von $SiO_2$ sowie $Cu_2O$ Phasen, in denen Cu(I) vorliegt, nachgewiesen wurde. Im Gegensatz dazu kommt es bei einem zu hohen Sauerstoffanteil unterhalb der in Tabelle 2, unter Bereich 2' angegebenen N/(N+O)-Grenzen, bspw. bei $H \leq 25$, zu einem steigenden Anteil von CuO-Phasen. Dabei haben sich solche kupfer(II)haltigen Verbindungen in den Versuchen als schwächer antimikrobiell herausgestellt. Bei einem zu hohen N/(N+O)-Verhältnis wiederum wird in steigendem Ausmass die Bildung von nitridischen Kupferverbindungen und/oder von elementarem Kupfer während des Beschichtungsprozesses vermutet. Überraschenderweise hat sich hier herausgestellt, dass insbesondere Kupfer(I)verbindungen, auch auf trockenen Oberflächen, sehr gute antimikrobielle Wirkung zeigen.

Ebenso überraschend stellte sich dabei heraus, dass bei Einstellung eines bestimmten N/(N+O)Verhältnisses in der Schicht ein Grossteil des Kupfers, bzw. sogar das gesamte Kupfer der Schicht einwertig, insbesondere als $Cu_2O$ und / oder $Cu_3N$ vorlag. Dies wurde zusätzlich noch durch die Einstellung eines bestimmten Si/(Cu + Si) Verhältnisses in der Schicht begünstigt (siehe Tabelle 6). So können bei hohen I-Werten, etwa im Bereich von 20 bis 30, zwar sehr dünne antimikrobiell wirksame Schichten abgeschieden werden, jedoch zeigen solche Schichten eine deutlich höhere Verschiebung der Absorptions- und/oder Farbwerte gegenüber unbeschichteten Glassubstraten. Dem hingegen können bei Wahl eines niedrigen I-Werts, beispielsweise im Bereich von 5 bis 15 auch verhältnismässig dicke Schichten abgeschieden werden ohne die optischen Eigenschaften negativ zu beeinflussen.

Analoge Versuche unter Verwendung von einem (metallischen, oxidischen, nitridischen oder oxinitridischen) Mischtarget, wie oben erwähnt, mit einer Targetzusammensetzung, $I_T$ = Cu / (Cu + Si) = 15 bis 30, an Stelle des Si- und des Cu-Targets haben zu einem ähnlichen Ergebnis geführt.

Die bei einer Schichtdicke von ca. 40 nm auf 4 mm dickem Kalk-Natron-Glas gemäss CIE Lab System, mit Lichtart C, unter einem Beobachtungswinkel 2° gemessenen optischen Eigenschaften im sichtbaren Wellenlängenbereich sind entsprechend in Tabelle 3 aufgelistet.

Tabelle 3

| | Beispiel | Bereich 1' | Bereich 2' |
|---|---|---|---|
| Absorption | 2.8 at% | 1 - 4 at% | 0 - 6 at% |
| Transmission | 82.8 at% | 79 - 90 at% | 70 - 95 at% |
| Reflexion | 14.4 at% | 9 - 16 at% | 4 - 20 at% |
| Farbwerte Refl. a*/b* | -0.3 / -6.0 | -1.5 - 0 / -7.2 - -4.5 | -4 - 2 / -8.5 - -2 |
| Farbwerte Transm. a*/b* | -0.9 / 3.2 | -1.3 - -0.5/ 1.5 - 5.5 | -3 - 2 / -1 - 8 |

Innerhalb der in Tabelle 4 gelisteten Schichtdickenbereiche konnten erfindungsgemässe antimikrobiell wirkende Schichten abgeschieden werden. Dabei wurde festgestellt, dass bei extrem dünnen Schichten etwa zwischen 1 bis 5 nm die antimikrobielle Wirkung mit der Zeit, beispielsweise durch Auswaschung, geringer werden kann. Diesem Effekt kann jedoch bspw. durch gleichzeitige Erhöhung des Verhältnisses I auf Werte zwischen 20 und 30 und/oder Einstellung des Wertes G auf Werte zwischen 47 und 52 entgegengewirkt werden. Damit weisen solche Schichten immer noch eine ausreichende bakterizide Wirkung von > 75% und eine nur geringe optische Abweichung gegenüber unbeschichtetem Normalglas (Vergleichsglas) auf.

Umgekehrt wächst bei grossen Schichtdicken, etwa von 80 bis 130 nm, die Abweichung der optischen Eigenschaften vom Vergleichsglas (Absorption, Farbwerte), weshalb sich solche Beschichtungen eher für opake oder bezüglich der Änderung ihrer optischen Eigenschaften unempfindliche Gegenstände eignen. In den Randbereichen des Bereichs B, also 5 bis 10 nm, bzw. 80 bis 130 nm können Schichten auf sehr gute optische Eigenschaften, bzw. Schichten auf sehr gute antimikrobielle Eigenschaften eingestellt werden, die gleichzeitig bspw. durch Einstellung des Cu-Gehalts auf bis zu 15 at% und/oder Zugabe eines Dotierelements, farblich abgestimmt sind. Demgegenüber konnten im gesamten Schichtdickenbereich A bei Auswahl der Schichtzusammensetzung gemäss der Bereiche 1 und 1' Schichten abgeschieden werden, die sowohl sehr gute optische als auch sehr gute antimikrobielle Eigenschaften aufweisen (siehe Tabelle 6).

Tabelle 4

|  | Bereich A | Bereich B | Bereich C |
|---|---|---|---|
| Schichtdicke | 10 - 50 nm | 5 - 80 nm | 1 - 130 nm |

Eine Zusammenstellung der antimikrobiellen, insbesondere bakteriziden bzw. fungiziden Eigenschaften bezüglich der in Spalte "Keim" angeführten Spezies gibt Tabelle 5. Die Prozentangaben beziehen sich dabei auf die kleinste gemessene Bakterienabtötung im Bereich A, B, C, bzw. auf die Bakterienabtötung bei einer Schichtzusammensetzung gemäss Beispiel.

Dazu wurden verschiedene Schichten mit einer Schichtkomposition gemäss Bereich 1, für alle Elemente nach oben beschriebener Testmethode getestet.

Tabelle 5

| Keim | Beispiel [%] | Bereich A [%] | Bereich B [%] | Bereich C [%] |
|---|---|---|---|---|
| S. aureus (gram +) | 87 | > 80 | > 75 | > 45 |
| E. faecalis (gram +) | 82 | > 80 | > 75 | > 45 |
| E. coli (gram -) | 90 | > 85 | > 80 | > 50 |
| A. Baumannii (gram -) | 100 | > 85 | > 80 | > 50 |
| C. albicans (Pilz) | 71 | > 65 | > 60 | > 40 |

Die ausgewählten Keime für die antibakteriellen, bzw. den ebenfalls durchgeführten antifungizide Test sind dabei repräsentativ. Die antimikrobielle Wirkung beschränkt sich selbstverständlich nicht nur auf diese aufgeführten Keime.

Tabelle 6 zeigt eine Gegenüberstellung der antimikrobiellen Wirksamkeiten und von optischen Testergebnissen für Schichtzusammensetzungen im Bereich 1' (oder 1) der Tabelle 2 bezüglich der Verhältniszahlen I = Cu / (Cu+Si) und H = N / (N+O), bei einer Schichtdicke im Bereich B der Tabelle 5. Dabei zeigt sich, dass Schichten mit I < 15 und/oder H < 35 zwar noch gute optische Eigenschaften aufweisen, jedoch verhältnismässig schwach antimikrobiell sind. Umgekehrt zeigen Schichten mit I > 20 und/oder H > 45 zwar gute antimikrobielle Eigenschaften, sind jedoch für optische Zwecke auf Grund der grösseren Abweichungen, insbesondere der Absorption von sichtbarem Licht und der Farbwerte, nur noch bedingt zu gebrauchen. Ein sowohl bezüglich der optischen als auch bezüglich der antimikrobiellen Eigenschaften sehr gutes Ergebnis lässt sich innerhalb der Grenzen I = 15 - 20 erzielen, dies insbesondere wenn gleichzeitig H = 35 - 45.

Tabelle 6

| Mengenverhältnis | Bakterien-Abtötung [%] | Transm. [%] | efl. [%] | Farbwerte Reflexion a* / b* | Farbwerte Transmission a* / b* |
|---|---|---|---|---|---|
| I = 15 - 20 at% | > 75 | 79 - 90 | 9-16 | -1.5 - 0 / -7.2 - -4.5 | -1.3 - -05 / 1.5 - 5.5 |
| I < 15 at% | < 45 | 79 - 90 | 9-16 | -1.5 - 0 / -7.2 - -4.5 | -1.3 - -0.5 / 1.5 - 5.5 |
| I > 20 at% | > 75 | < 79 | > 16 | < -1.5 / < -7.2 | < -1.3 / > 5.5 |
| H = 35 - 45 at% | > 75 | 79 - 90 | 9 - 16 | -1.5 - 0 / -7.2 - -4.5 | -1.3 - -0.5 / 1.5 - 5.5 |
| H < 35 at% | < 45 | 79 - 90 | 9 - 16 | -1.5 - 0 / -7.2 - -4.5 | -1.3 - -0.5 / 1.5 - 5.5 |

Die in der vorliegenden Beschreibung ausgeführten Beispiele und Kombinationen verschiedener Ausführungen dienen lediglich der Veranschaulichung einzelner Aspekte, schränken jedoch nicht den Schutzbereich der Erfindung ein, da auch andere Kombinationen möglich, bzw. alle genannten Beispiele und Ausführungen grundsätzlich miteinander kombinierbar sind und unter den Schutzbereich der Erfindung fallen, solange dies nicht, wie für den Fachmann ohne weiteres ersichtlich, sinnwidrig ist.

**Patentansprüche**

1. Gegenstand mit einer auf zumindest einer Oberfläche des Gegenstands angeordneten Beschichtung, die zumindest eine antimikrobiell wirkende Schicht mit einem antimikrobiellen Mittel umfasst, wobei das Mittel eine Kupfer(I)-Verbindung oder/und eine Kupfer(II)-Verbindung sowie Silizium, Stickstoff und Sauerstoff umfasst, **dadurch gekennzeichnet, dass** in der Schicht ein Verhältnis, alle Angaben in at%,

$$G = (Cu + Si) / (Cu + Si + N + O + D)$$

von

$$32 \leq G \leq 52$$

vorliegt, wobei D für ein oder mehrere fakultative Dotierelemente steht.

2. Gegenstand gemäss Anspruch 1 **dadurch gekennzeichnet, dass** das antimikrobielle Mittel ein Oxid, ein Oxinitrid oder ein Nitrid ist.

3. Gegenstand gemäss einem der vorhergehenden Ansprüche, **dadurch gekennzeichnet, dass** das Mittel und/oder $Cu_3N$ ist.

4. Gegenstand gemäss einem der vorhergehenden Ansprüche, **dadurch gekennzeichnet, dass** die Schicht zumindest 2 at% Kupfer, bevorzugt zumindest 6 at% Kupfer umfasst.

5. Gegenstand gemäss einem der vorhergehenden Ansprüche **dadurch gekennzeichnet, dass** zwischen der Schicht und der Oberfläche zumindest eine Zwischenschicht angeordnet ist.

6. Gegenstand gemäss Anspruch 5 **dadurch gekennzeichnet, dass** die Zwischenschicht eine aus zumindest einer hochbrechenden und einer tiefbrechenden Schichtlage, dabei bevorzugt aus zumindest zwei hochbrechenden und zwei tiefbrechenden Schichtlagen bestehende Antireflexschicht umfasst, wobei der Gegenstand bevorzugt ein Glas ist.

7. Gegenstand gemäss einem der vorhergehenden Ansprüche, **dadurch gekennzeichnet, dass** die Schicht zumindest 25 at% Silizium, zumindest 40 at% Nichtmetalle und das Dotierelement in einem Bereich von $0 \leq D \leq 15$ at% enthält.

8. Gegenstand gemäss einem der vorhergehenden Ansprüche **dadurch gekennzeichnet, dass** das Dotierelement D zumindest eines der folgenden Metalle umfasst: Ag, Al, Cd, Sn, As, Fe, Mn, Ni, Zn, Cr.

9. Gegenstand gemäss einem der vorhergehenden Ansprüche, **dadurch gekennzeichnet, dass** auf einer dem Gegenstand abgewandten Schichtoberfläche eine hydro- oder/und eine oleophobe Schicht angeordnet ist.

10. Gegenstand gemäss einem der der vorhergehenden Ansprüche, **dadurch gekennzeichnet, dass** der Gegenstand ein Glas, dabei insbesondere ein mineralisches Glas ist.

11. Verfahren zur Beschichtung eines Gegenstandes mit einer antimikrobiellen Schicht umfassend folgende Schritte:

   - Bereitstellen einer Sputteranlage mit zumindest einem kupferhaltigen Target;
   - Einbringen des Gegenstandes in die Sputteranlage;
   - Erzeugen eines Vakuums in der Sputteranlage;
   - Einlassen eines inerten Sputtergases sowie eines Sauerstoff und/oder Stickstoff enthaltenden Reaktivgases;
   - Zünden und Aufrechterhalten einer Sputterentladung an dem kupferhaltigen Target
   - Einstellen des Reaktivgasflusses so, dass auf dem Gegenstand eine Schicht abgeschieden wird, die eine Kupfer(I)-Verbindung oder/und eine Kupfer(II)-Verbindung, dabei bevorzugt ein Oxid, ein Oxinitrid oder/und ein Nitrid des Kupfers enthält,

**dadurch gekennzeichnet, dass** das Target ein kupfersiliziumhaltiges Target ist, wobei ein Verhältnis, alle Angaben in at%,

$$I_T = Cu / (Cu + Si)$$

im Target in einem Bereich von

$$5 \leq I_T \leq 40$$

vorliegt.

12. Verfahren nach Anspruch 11, **dadurch gekennzeichnet, dass** das kupferhaltige Target ein CuSi-Target, ein Kupfersiliziumoxidtarget, ein Kupfersiliziumnitridtarget oder ein Kupfersiliziumoxinitridtarget ist.

13. Verfahren zur Beschichtung eines Gegenstandes mit einer antimikrobiellen Schicht umfassend folgende Schritte:

- Bereitstellen einer Sputteranlage mit zumindest einem kupferhaltigen Target;
- Einbringen des Gegenstandes in die Sputteranlage;
- Erzeugen eines Vakuums in der Sputteranlage;
- Einlassen eines inerten Sputtergases sowie eines Sauerstoff und/oder Stickstoff enthaltenden Reaktivgases;
- Zünden und Aufrechterhalten einer Sputterentladung an dem kupferhaltigen Target;
- Einstellen des Reaktivgasflusses so, dass auf dem Gegenstand eine Schicht abgeschieden wird, die eine Kupfer(I)-Verbindung oder/und eine Kupfer(II)-Verbindung, dabei bevorzugt ein Oxid, ein Oxinitrid oder/und ein Nitrid des Kupfers enthält,

**dadurch gekennzeichnet, dass** das kupferhaltige Target ein Cu-Target, ein Kupfer(I) enthaltendes Target, ein Kupfer(II) oder beide Oxidationsstufen des Kupfers enthaltendes Target, insbesondere ein Kupfertarget, ein Kupfernitridtarget, ein Kupferoxidtarget oder/und ein Kupferoxinitridtarget ist und die Sputteranlage des Weiteren zumindest ein Siliziumtarget, ein Siliziumoxidtarget ein Siliziumnitridtarget, oder/und ein Siliziumoxinitridtarget umfasst, wobei das Verfahren die folgenden weiteren Schritte umfasst:

- Zünden und Aufrechterhalten einer Sputterentladung an dem Si-haltigen Target;
- wobei die kupferhaltigen und siliziumhaltigen Targets auf die zu beschichtende Oberfläche ausgerichtet sind;
- Einstellung der Sputterraten am Cu-haltigen Target und am Si-haltigen Target, um in der Schicht ein Verhältnis, alle Angaben in at%,

$$I = Cu / (Cu + Si)$$

von

$$5 \leq I \leq 30$$

einzustellen.

14. Verfahren nach Anspruch 11 bis 13, **dadurch gekennzeichnet, dass** die Schritte so gewählt werden, dass eine $Cu_2O$- und/oder eine $Cu_3N$-Schicht abgeschieden wird.

15. Verfahren nach einem der Ansprüche 11 bis 14, **gekennzeichnet durch**

- Einstellung des Partialdrucks des sauerstoffhaltigen Gases sowie des Partialdrucks des stickstoffhaltigen Gases, um in der Schicht ein Verhältnis, alle Angaben in at%,

$$H = N / (N + O)$$

von

$$30 \leq H \leq 50$$

einzustellen.

16. Gegenstand gemäss einem der Ansprüche 1 bis 10, hergestellt nach einem Verfahren gemäss Ansprüchen 11 bis 15.

## Claims

1. Article with a coating arranged on at least one surface of the article, which coating comprises at least one antimicrobially acting layer with an antimicrobial agent, wherein the agent comprises a copper(I) compound and/or a copper(II) compound as well as silicon, nitrogen and oxygen, **characterized in that** in the layer, all data in at%, a ratio

$$G = (Cu + Si) / (Cu + Si + N + O + D)$$

of

$$32 \leq G \leq 52$$

is present, wherein D stands for one or more optional doping elements.

2. Article according to claim 1 **characterized in that** the antimicrobial agent is an oxide, an oxynitride or a nitride.

3. Article according to one of the preceding claims, **characterized in that** the agent is and/or $Cu_3N$.

4. Article according to one of the preceding claims, **characterized in that** the layer comprises at least 2 at% copper, preferably at least 6 at% copper.

5. Article according to one of the preceding claims, **characterized in that** at least one intermediate layer is arranged between the layer and the surface.

6. Article according to claim 5, **characterized in that** the intermediate layer comprises an anti-reflection layer consisting of at least one high refractive and one low refractive layer, preferably at least two high refractive and two low refractive layers, wherein the article is preferably a glass.

7. Article according to one of the preceding claims, **characterized in that** the layer contains at least 25 at% silicon, at least 40 at% non-metals and the doping element in a range of $0 \leq D \leq 15$ at%.

8. Article according to one of the preceding claims, **characterized in that** the doping element D comprises at least one of the following metals: Ag, Al, Cd, Sn, As, Fe, Mn, Ni, Zn, Cr.

9. Article according to one of the preceding claims, **characterized in that** a hydrophobic and/or oleophobic layer is arranged on a layer surface facing away from the article.

10. Article according to one of the preceding claims, **characterized in that** the article is a glass, thereby in particular a mineral glass.

11. Method for coating an article with an antimicrobial layer comprising the following steps:

   - providing a sputtering device with at least one copper-containing target;
   - introducing the article into the sputtering device;
   - creating a vacuum in the sputtering device;
   - admitting an inert sputter gas and a reactive gas containing oxygen and/or nitrogen;
   - igniting and maintaining a sputter discharge on the copper-containing target;
   - adjusting the reactive gas flow so that a layer containing a copper(I) compound and/or a copper(II) compound, preferably an oxide, an oxynitride and/or a nitride of the copper, is deposited on the article,

   **characterized in that** the target is a copper-silicon-containing target, wherein a ratio, all data in at%,

$$I_T = Cu \, / \, (Cu + Si)$$

   in the target in a range of

$$5 \leq I_T \leq 40$$

   is present.

12. Method according to claim 11, **characterized in that** the copper-containing target is a CuSi target, a copper-silicon oxide target, a copper-silicon nitride target or a copper-silicon oxynitride target.

13. Method for coating an article with an antimicrobial layer, comprising the steps of:

   - providing a sputtering device with at least one copper-containing target;
   - introducing the article into the sputtering device;
   - creating a vacuum in the sputtering device;
   - introducing an inert sputtering gas and a reactive gas containing oxygen and/or nitrogen;
   - igniting and maintaining a sputter discharge on the copper-containing target;
   - adjusting the reactive gas flow so that a layer containing a copper(I) compound and/or a copper(II) compound, preferably an oxide, an oxynitride and/or a nitride of the copper, is deposited on the article,

   **characterized in that** the copper-containing target is a Cu target, a target containing copper(I), a target containing copper(II) or a target containing both oxidation states of the copper, in particular a copper target, a copper nitride target, a copper oxide target and/or a copper oxynitride target, and the sputtering device further comprises at least one of a silicon target, a silicon oxide target, a silicon nitride target and/or a silicon oxynitride target, wherein the method comprises the following further steps:

   - igniting and maintaining a sputter discharge at the Si-containing target;
   - wherein the copper-containing and silicon-containing targets are aligned with the surface to be coated;
   - adjusting the sputtering rates at the Cu-containing target and at the Si-containing target to set in the layer a ratio, all data in at%,

$$I = Cu \, / \, (Cu + Si)$$

   of

$$5 \leq I \leq 30.$$

14. Method according to claim 11 to 13, **characterized in that** the steps are selected such that a and/or a $Cu_3N$ layer is deposited.

**15.** Method according to one of claims 11 to 14, **characterized by**

- adjusting the partial pressure of the oxygen-containing gas as well as the partial pressure of the nitrogen-containing gas in order to set a ratio in the layer, all data in at%,

$$H = N / (N + O)$$

of

$$30 \leq H \leq 50.$$

**16.** Article according to one of claims 1 to 10, manufactured by a method according to claims 11 to 15.

**Revendications**

**1.** Objet avec un revêtement agencé sur au moins une surface de l'objet, lequel revêtement comprend au moins une couche antimicrobienne avec un agent antimicrobien, l'agent comprenant un composé de cuivre (I) et/ou un composé de cuivre (II) ainsi que du silicium, de l'azote et de l'oxygène, **caractérisé en ce que** dans la couche il y a un rapport, toutes les données étant en pourcentage atomique,

$$G = (Cu + Si) / (Cu + Si + N + O + D)$$

de

$$32 \leq G \leq 52$$

D représentant un ou plusieurs éléments dopants facultatifs.

**2.** Objet selon la revendication 1, **caractérisé en ce que** l'agent antimicrobien est un oxyde, un oxynitrure ou un nitrure.

**3.** Objet selon l'une des revendications précédentes, **caractérisé en ce que** l'agent est du $Cu_2O$ et/ou $Cu_3N$.

**4.** Objet selon l'une des revendications précédentes, **caractérisé en ce que** la couche comprend au moins 2 % en pourcentage atomique de cuivre, de préférence au moins 6 % en pourcentage atomique de cuivre.

**5.** Objet selon l'une des revendications précédentes, **caractérisé en ce qu'**il est agencé au moins une couche intermédiaire entre la couche et la surface.

**6.** Objet selon la revendication 5, **caractérisé en ce que** la couche intermédiaire comprend une couche antireflet composée d'au moins une couche de film de réfraction élevé et d'une couche de film de réfraction faible, de préférence composée d'au moins deux couches de film de réfraction élevé et de deux couches de film de réfraction faible, l'objet étant de préférence un verre.

**7.** Objet selon l'une des revendications précédentes, **caractérisé en ce que** la couche contient au moins 25 % en pourcentage atomique de silicium, au moins 40 % en pourcentage atomique de non-métaux et l'élément dopant dans une plage de $0 \leq D \leq 15$ % en pourcentage atomique.

**8.** Objet selon l'une des revendications précédentes, **caractérisé en ce que** l'élément dopant D comprend au moins un des métaux suivants : Ag, Al, Cd, Sn, As, Fe, Mn, Ni, Zn, Cr.

**9.** Objet selon l'une des revendications précédentes, **caractérisé en ce qu'**il est agencé sur une surface de la couche orientée à l'opposé de l'objet une couche hydrophobe et/ou une couche oléophobe.

**10.** Objet selon l'une des revendications précédentes, **caractérisé en ce que** l'objet est un verre, en particulier un verre minéral.

**11.** Procédé pour revêtir un objet d'une couche antimicrobienne comprenant les étapes suivantes:

- fournir une installation de pulvérisation avec au moins une cible contenant du cuivre;
- amener l'objet dans l'installation de pulvérisation;
- produire un vide dans l'installation de pulvérisation;
- amener un gaz de pulvérisation inerte ainsi qu'un gaz réactif contenant de l'oxygène et/ou de l'azote;
- amorcer et maintenir une décharge de pulvérisation sur la cible contenant du cuivre;
- régler le flux de gaz réactif de façon à séparer sur l'objet une couche qui contient un composé de cuivre (I) et/ou un composé de cuivre (II), de préférence un oxyde, un oxynitrure et/ou un nitrure de cuivre,

**caractérisé en ce que** la cible est une cible contenant du cuivre-silicium, avec un rapport, toutes les données étant en pourcentage atomique,

$$I_T = Cu / (Cu + Si)$$

dans la cible dans une plage de

$$5 \leq I_T \leq 40.$$

**12.** Procédé selon la revendication 11, **caractérisé en ce que** la cible contenant du cuivre est une cible CuSi, une cible cuivre-silicium-oxyde, une cible cuivre-silicium-nitrure ou une cible cuivre- silicium-oxynitrure.

**13.** Procédé pour revêtir un objet d'une couche antimicrobienne comprenant les étapes suivantes:

- fournir une installation de pulvérisation avec au moins une cible contenant du cuivre;
- amener l'objet dans l'installation de pulvérisation;
- produire un vide dans l'installation de pulvérisation;
- amener un gaz de pulvérisation inerte ainsi qu'un gaz réactif contenant de l'oxygène et/ou de l'azote;
- amorcer et maintenir une décharge de pulvérisation sur la cible contenant du cuivre;
- régler le flux de gaz réactif de façon à séparer sur l'objet une couche qui contient un composé de cuivre (I) et/ou un composé de cuivre (II), de préférence un oxyde, un oxynitrure et/ou un nitrure de cuivre,

**caractérisé en ce que** la cible contenant du cuivre est une cible Cu, une cible contenant du cuivre (I), une cible contenant un cuivre (II) ou les deux étapes d'oxydation du cuivre, en particulier une cible cuivre, une cible nitrure de cuivre, une cible oxyde de cuivre et/ou une cible oxynitrure de cuivre, et **en ce que** l'installation de pulvérisation comprend en outre une cible silicium, une cible oxyde de silicium, une cible nitrure de silicium et/ou une cible oxynitrure de silicium, le procédé comprenant en outre les étapes suivantes consistant à:

- amorcer et maintenir une décharge de pulvérisation sur la cible contenant du Si;
- les cibles contenant du cuivre et du silicium étant orientées sur la surface à revêtir;
- régler les taux de pulvérisation sur la cible contenant du Cu et sur la cible contenant du Si pour régler dans la couche un rapport, toutes les données étant en pourcentage atomique,

$$I = Cu / (Cu + Si)$$

de

$$5 \leq I \leq 30.$$

**14.** Procédé selon les revendications 11 à 13, **caractérisé en ce que** les étapes sont choisies de façon à séparer une couche $Cu_2O$ et/ou une couche $Cu_3N$.

**15.** Procédé selon l'une des revendications 11 à 14, **caractérisé par** une étape consistant à

- régler la pression partielle du gaz contenant de l'oxygène ainsi que la pression partielle du gaz contenant de l'azote, pour régler dans la couche un rapport, toutes les données étant en pourcentage atomique,

$$H = N / (N + O)$$

de

$$30 \leq H \leq 50.$$

**16.** Objet selon l'une des revendications 1 à 10, fabriqué selon un procédé selon les revendications 11 à 15.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102006060057 A1
- US 20150225288 A1
- EP 1828071 B2
- EP 1828071 A